# EUROPÄISCHE PATENTSCHRIFT

(11) **EP 3 847 877 B1**
(45) Veröffentlichungstag und Bekanntmachung des Hinweises auf die Patenterteilung: **30.11.2022**
(21) Anmeldenummer: 19708799.2
(22) Anmeldetag: 25.02.2019
(51) Int. Cl.: H05K 13/02, H05K 13/08, B65G 1/04

(54) **ANLAGE ZUM LAGERN VON IN GURTSPULEN AUFGENOMMENEN ELEKTRISCHEN BAUELEMENTEN**
SYSTEM FOR STORING ELECTRICAL COMPONENTS ACCOMMODATED IN REELS
INSTALLATION DE STOCKAGE DE COMPOSANTS ÉLECTRIQUES LOGÉS DANS DES BOBINES DE CEINTURE

(30) Priorität: 03.09.2018 DE 102018121447
(43) Veröffentlichungstag der Anmeldung: 14.07.2021
(73) Patentinhaber: Otto Künnecke GmbH, 37603 Holzminden (DE)
(72) Erfinder: PHILIPP, Jürgen, 79639 Grenzach-Wyhlen (DE)
(74) Vertreter: Müller Hoffmann & Partner
(86) Internationale Anmeldenummer: PCT/EP2019/054586
(87) Internationale Veröffentlichungsnummer: WO 2020/048645

(56) Entgegenhaltungen:
- DE-T2- 69 908 271
- JP-A- 2005 089 041
- US-A- 3 456 817
- US-A- 4 651 863
- US-A- 5 321 885

## Beschreibung

Die Erfindung bezieht sich auf eine Anlage zum Lagern von in Gurtspulen aufgenommenen elektrischen Bauelementen, wobei die Gurtspulen in Ablagefächern von zumindest einer Regaleinrichtung lagerbar sind, wobei der Regaleinrichtung eine höhenverstellbare Greifeinrichtung zur Eingabe der Gurtspulen in die Ablagefächer bzw. zur Entnahme der Gurtspulen aus den Ablagefächern zugeordnet ist und wobei die die Gurtspulen durch die Greifeinrichtung zwischen einem Bereitstellplatz der Anlage und den Ablagefächern transportierbar sind

Eine derartige Anlage ist durch die DE 10 2013 006 524 A1 bekannt geworden. Danach sind stationäre Ablagefächer in senkrechter und waagerechter Richtung aneinander gereiht. Jeweils eine Gurtspule ist mittels einer in beiden Richtungen verfahrbaren Greifeinrichtung zwischen einem der Ablagefächer und einer Übergabestation transportierbar, die einer Ein-/Ausgabestation der Anlage zugeordnet ist. Die Greifeinrichtung weist eine Vielzahl von Funktionen auf, die die Zykluszeit für das Einlagern bzw. Auslagern der Gurtspulen erhöht. Durch die flächige Verteilung der Ablagefächer ist insbesondere die waagerechte Erstreckung Regaleinrichtung entsprechend groß, was lange Verfahrwege der Greifeinrichtung mit entsprechend großen Zykluszeiten für jeweils eine Gurtspule bedingt.

Ferner ist durch die DE 20 2004 006 920 U1 eine rundturmartige Anlage mit peripher kreisförmig verteilten Ablagefächern bekannt geworden. Ein zentraler schwenkbarer Roboterarm ist in der Höhe verfahrbar und waagerecht radial verschiebbar und transportiert die Gurtspulen zwischen einer Eingabestation und den Ablagefächern. Da diese außerhalb des Verfahrraums des als Greifeinrichtung dienenden Roboterarms liegen müssen, wird der Außendurchmesser der Anlage entsprechend groß.

Aus der JP 2005 089041 A ist eine Anlage zum Lagern von in Gurtspulen aufgenommenen elektrischen Bauelementen bekannt, mit einem um eine senkrechte Drehachse drehbaren zylinderartigen Drehgestell.

In der US 4 651 863 A ist ein System zum Bereitstellen von elektronischen Komponenten beschrieben, mit karussellartig bewegbaren Ablagefächern auf mehreren Etagen.

Die DE 699 08 271 T2 offenbart eine Vorrichtung zum automatischen Speichern von biologischen oder chemischen Proben, mit einer höhenverstellbaren Greifeinrichtung.

Aus der US 3 456 817 A ist ebenfalls eine Regaleinrichtung mit Ablagefächern und eine höhenverstellbare Greifeinrichtung bekannt.

In der US 5 321 885 A wird ein System zum Bestücken von Leiterplatten beschrieben.

Der Erfindung liegt die Aufgabe zugrunde, die Ausdehnung der Anlage kompakter zu gestalten, die Mechanik der Regaleinrichtung zu vereinfachen und die Zykluszeiten der Gurtspulen zu verkürzen.

Diese Aufgabe wird durch die Erfindung gemäß Anspruch 1 gelöst. Vorteilhafte Weiterbildungen der Erfindung sind in den abhängigen Ansprüchen angegeben.

Es wird eine Anlage zum Lagern von in Gurtspulen aufgenommenen elektrischen Bauelementen angegeben, wobei die Gurtspulen in Ablagefächern von zumindest einer Regaleinrichtung lagerbar sind, der Regaleinrichtung eine höhenverstellbare Greifeinrichtung zur Eingabe der Gurtspulen in die Ablagefächer bzw. zur Entnahme der Gurtspulen aus den Ablagefächern zugeordnet ist und wobei die Gurtspulen durch eine Greifeinrichtung zwischen einem Bereitstellplatz der Anlage und den Ablagefächern transportierbar sind. Die Anlage ist dadurch gekennzeichnet, dass die Regaleinrichtung ein um eine senkrechte Drehachse drehbares zylinderartiges Drehgestell aufweist, an dem die Ablagefächer in mehreren Lagen übereinander gereiht ausgebildet sind, die einzelnen Lagen in einer Ebene jeweils mehrere der zirkulär verteilten Ablagefächer aufweisen, die Greifeinrichtung an einer außerhalb des Drehgestells angeordneten stationären senkrechten Linearführung verschiebbar gelagert ist, jedes der Ablagefächer des Drehgestells in eine auf die Greifeinrichtung einstellbare Drehlage bewegt werden kann und dass der Bereitstellplatz im Zugriffsbereich der Greifeinrichtung angeordnet ist.

Das von außen bedienbare zylindrische Drehgestell ermöglicht einen kompakten Aufbau der Regaleinrichtung. Da die Gurtspulen nahe der Drehachse gelagert werden können, wird der Außendurchmesser entsprechend gering. Während das Drehgestell verdreht wird, kann die Greifeinrichtung bereits eine weitere Gurtspule vom Bereitstellplatz abholen und vor das nächste Abholfach transportieren. Durch diese Parallelisierung der Bewegungen wird die Zykluszeit erheblich verringert.

Die höhenverstellbare Greifeinrichtung weist einen waagerecht verschiebbaren Greifer auf. Sie benötigt also nur 2 Freiheitsgrade und kann daher entsprechend einfach gestaltet werden.

Das Drehgestell kann z.B. mittels eines Stellmotors über einen einfachen Zahnriemenantrieb verdreht werden.

Die Anlage weist einen Bandtransport auf, durch den die Gurtspulen zwischen einer Eingabestation und/oder einer Ausgabestation und dem Bereitstellplatz transportierbar sind. Durch den Bandtransport wird die Eingabe der Gurtspulen vom Weitertransport in die Ablagefächer zeitsparend entkoppelt. Die Ein-/Ausgabestation kann an einer gut zugänglichen Stelle der Anlage angeordnet werden.

Mehrere der Regaleinrichtungen mit mehreren der Greifeinrichtungen sind entlang einer Transportstrecke des Bandtransports in einer Reihe in einer waagerechten Längsrichtung hintereinanderliegend angeordnet, wobei die den einzelnen Regaleinrichtungen zugeordneten Bereitstellplätze durch Haltepositionen des Bandtransports gebildet sind.

Durch diese Weiterbildung wird die Kapazität der Anlage erheblich erhöht. Jeweils eine der Regaleinrichtungen bildet mit der zugehörigen Greifeinrichtung ein einfaches kompaktes Lagermodul, dass nicht nur nahe einer Bestücklinie für Leiterplatten, sondern auch in entsprechender Vervielfachung in einem Zentrallager für die Gurtspulen eingesetzt werden kann.

Der Bandtransport kann in den einzelnen Regaleinrichtungen zugeordnete autonome Teiltransporte unterteilt sein. Die Teiltransporte können einzeln angetrieben und gesteuert werden, so dass auf der Transportstrecke mehrere Gurtspulen gleichzeitig transportiert werden können.

Jeweils eine der Regaleinrichtungen kann mit dem zugeordneten Teiltransport , der Linearführung und der zugehörigen Greifeinrichtung eine modulartige Funktionseinheit bilden. Die Funktionseinheit bildet einen einheitlichen autonomen Grundbaustein für unterschiedlich konfigurierbare Anlagen, bei denen anstelle einer der Funktionseinheiten auch ein anderes Gerät angeordnet sein kann, z.B. eine Messeinrichtung zum Ermitteln der Anzahl von Bauelementen, die in einer der Gurtspulen enthalten sind.

Mehrere der Reihen können in einer zur Längsrichtung senkrechten waagerechten Querrichtung nebeneinander angeordnet und durch einen Quertransport des Bandtransports verbunden sein. Dabei können die Regaleinrichtungen in einer Flächenmatrix verteilt angeordnet sein.

Durch diese Weiterbildungen kann die Anzahl der Regaleinrichtungen erheblich erhöht werden. Es versteht sich, dass die verschiedenen Reihen durch bandartige Quertransporte des Bandtransports verbunden sind. Dadurch ist gewährleistet, dass die Transport- und Zykluszeiten der Gurtspulen auch bei einer hohen Anzahl von Regaleinrichtungen geringgehalten werden können.

Der Bandtransport kann einen autonomen Eingabetransport und einen autonomen Ausgabetransport aufweisen, wobei die beiden Transporte jeweils in übereinanderliegenden Ebenen angeordnet sind. Die Trennung des Bandtransports in den Eingabe- und den Ausgabetransport ermöglicht es, die Gurtspulen voneinander unbeeinflusst zu transportieren, wodurch die Transportleistung erheblich gesteigert werden kann.

Der Bandtransport kann insbesondere an den Bereitstellplätzen Zentriereinrichtungen für die Gurtspulen aufweisen. Die Zentriereinrichtung kann z.B. einen optischen Sensor zur genauen Ermittlung der Lage der bereitliegenden Gurtspule ausweisen. Es ist aber auch möglich, mechanische Zentriermittel einzusetzen, um die Gurtspule von der Greifeinrichtung definiert erfassen zu können.

Im Folgenden wird die Erfindung anhand eines in der Zeichnung dargestellten Ausführungsbeispieles näher erläutert. Es zeigen:
- **Figur 1**: eine schematisierte Seitenansicht einer Anlage zum Lagern von elektrische Bauelemente aufnehmenden Gurtspulen; und
- **Figur 2**: eine Draufsicht auf die Anlage nach Figur 1,

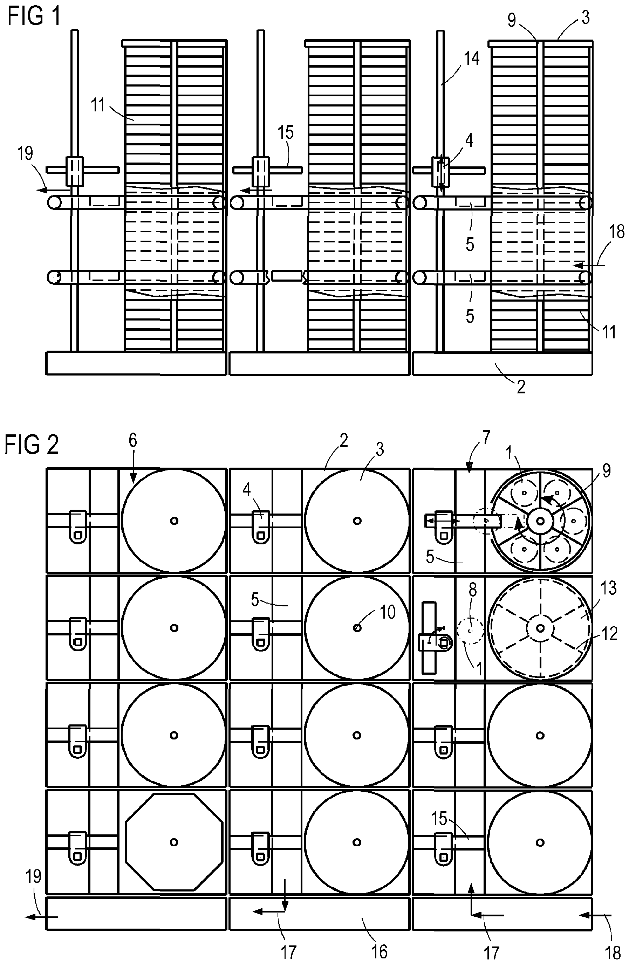

Nach den Figuren 1 und 2 ist eine Anlage zum Lagern von Gurtspulen 1 aus einer Vielzahl von zellenartigen Funktionseinheiten 2 zusammengesetzt, die aus jeweils einer Regaleinrichtung 3, einer Greifeinrichtung 4 und einem Teiltransport 5 gebildet sind.

Die Funktionseinheiten 2 sind in einer zweidimensionalen Anordnung matrixartig in mehreren Reihen 6 und Zeilen verteilt. Die waagerechten Teiltransporte 5 erstrecken sich fluchtend in der Reihenrichtung und bilden jeweils eine durchgehende Transportstrecke 7 eines Bandtransportes, der nahe an den Regaleinrichtungen 2 der jeweiligen Reihe 6 vorbeigeführt ist. Haltepositionen auf den Teiltransporten 5 bilden Bereitstellplätze 8 für die Gurtspulen 1 im Zugriffsbereich der Greifeinrichtungen 4.

Die Regaleinrichtungen 3 weisen jeweils ein Drehgestell 9 auf, das um eine senkrechte Drehachse 10 drehbar gelagert ist, entlang der waagerechte Regalböden 11 stapelartig aneinandergereiht sind. Auf jedem der Regalböden 11 stehen senkrechte Zwischenwände 12, die die Etagen zwischen den Regalböden 11 in gleichmäßige Segmente unterteilen. Die dadurch gebildeten Kammern dienen als Ablagefächer 13 für die zugeführten Gurtspulen 1. Das Drehgestell 9 ist derart verdrehbar, das jeweils eines der Ablagefächer 13 auf eine Öffnung in einem Mantel der Regaleinrichtung 3 einstellbar ist, die auf die zugehörige Greifeinrichtung 4 ausgerichtet ist.

Die Greifeinrichtung 4 ist an einer stationären senkrechten Stange der Funktionseinheit 2 senkrecht verschiebbar und kann so auf eine der Etagen eingestellt werden, wobei die Stange eine Linearführung 14 bildet.

Ein Schieber 15 der Greifeinrichtung 4 ist waagerecht in die Richtung der Drehachse 10 des Drehgestells 9 in das offene Ablagefach 13 verschiebbar. Der Schieber 15 weist nicht näher dargestellte Greifmittel zum Greifen der Gurtspulen 1 auf, um diese vom Bereitstellplatz 8 in das gewünschte Ablagefach zu transportieren. Die Linearführung 14, der Teiltransport 5 und die Regaleinrichtung 3 können an einem gemeinsamen Grundkörper verankert sein.

Die Transportstrecken 7 der verschiedenen Reihen 6 verlaufen in gleicher Höhe und grenzen an einer Stirnseite der Anlage an einen bandartigen Quertransport 16 des Bandtransports. Der Quertransport 16 dient der Zu- und Abführung der Gurtspulen 1, wobei diese mittels Übergabeeinrichtungen 17 zwischen dem Quertransport und den Transportstrecken 7 übergeben werden können (s.a. Pfeile in Fig. 2).

Der Bandtransport ist auf zwei übereinanderliegende Ebenen verteilt (vgl. Fig. 1), von denen eine einen Eingabetransport und der andere einen Ausgabetransport bildet, wobei der Eingabetransport an einer Eingabestation 18 beginnt und der Ausgabetransport an einer Ausgabestation 19 endet.

### Bezugszeichen

- 1: Gurtspule
- 2: Funktionseinheit
- 3: Regaleinrichtung
- 4: Greifeinrichtung
- 5: Teiltransport
- 6: Reihe
- 7: Transportstrecke
- 8: Bereitstellplatz
- 9: Drehgestell
- 10: Drehachse
- 11: Regalboden
- 12: Zwischenwand
- 13: Ablagefach
- 14: Linearführung
- 15: Schieber
- 16: Quertransport
- 17: Übergabeeinrichtung
- 18: Eingabestation
- 19: Ausgabestation

## Patentansprüche

1. Anlage zum Lagern von in Gurtspulen (1) aufgenommenen elektrischen Bauelementen, wobei
- die Gurtspulen (1) in Ablagefächern (13) von zumindest einer Regaleinrichtung (3) lagerbar sind,
- der Regaleinrichtung (3) eine höhenverstellbare Greifeinrichtung (4) zur Eingabe der Gurtspulen (1) in die Ablagefächer (13) bzw. zur Entnahme der Gurtspulen (1) aus den Ablagefächern (13) zugeordnet ist,
- die Gurtspulen (1) durch eine Greifeinrichtung (4) zwischen einem Bereitstellplatz (8) der Anlage und den Ablagefächern (13) transportierbar sind,
- die Regaleinrichtung (3) ein um eine senkrechte Drehachse (10) drehbares zylinderartiges Drehgestell (9) aufweist, an dem die Ablagefächer (13) in mehreren Lagen übereinander gereiht ausgebildet sind,
- die einzelnen Lagen in einer Ebene jeweils mehrere der zirkulär verteilten Ablagefächer (13) aufweisen,
- die Greifeinrichtung (4) an einer außerhalb des Drehgestells (9) angeordneten stationären senkrechten Linearführung (14) verschiebbar gelagert ist,
- jedes der Ablagefächer (13) des Drehgestells (9) in eine auf die Greifeinrichtung (4) einstellbare Drehlage bewegt werden kann,
- der Bereitstellplatz (8) im Zugriffsbereich der Greifeinrichtung (4) angeordnet ist,
-
die Anlage einen Bandtransport aufweist,
durch den die Gurtspulen (1) zwischen einer Eingabestation (18) und/oder einer Ausgabestation (19) und dem Bereitstellplatz (8) transportierbar sind,
- mehrere der Regaleinrichtungen (3) mit mehreren der Greifeinrichtungen (4) entlang einer Transportstrecke (7) des Bandtransports in einer Reihe (6) in einer waagerechten Längsrichtung hintereinanderliegend angeordnet sind, und wobei
- die den einzelnen Regaleinrichtungen (3) zugeordneten Bereitstellplätze (8) durch Haltepositionen des Bandtransports gebildet sind.

2. Anlage nach Anspruch 1, **dadurch gekennzeichnet, dass**
der Bandtransport in den einzelnen Regaleinrichtungen (3) zugeordnete autonome Teiltransporte (5) unterteilt ist.

3. Anlage nach Anspruch 1 oder 2, **dadurch gekennzeichnet, dass** jeweils eine der Regaleinrichtungen (3) mit dem zugeordneten Teiltransport (5), der Linearführung und der zugehörigen Greifeinrichtung (4) eine Funktionseinheit (2) bildet.

4. Anlage nach einem der vorhergehenden Ansprüche, **dadurch gekennzeichnet, dass** mehrere der Reihen (6) in einer zur Längsrichtung senkrechten waagerechten Querrichtung nebeneinander angeordnet und durch einen Quertransport (16) des Bandtransports verbunden sind.

5. Anlage nach Anspruch 4, **dadurch gekennzeichnet, dass**
die Regaleinrichtungen (3) in einer Flächenmatrix verteilt angeordnet sind.

6. Anlage nach einem der vorhergehenden Ansprüche, **dadurch gekennzeichnet, dass**
- der Bandtransport einen autonomen Eingabetransport und einen autonomen Ausgabetransport aufweist und dass
- die beiden Transporte jeweils in übereinanderliegenden Ebenen angeordnet sind.

7. Anlage nach einem der vorhergehenden Ansprüche, **dadurch gekennzeichnet, dass** der Bandtransport insbesondere an den Bereitstellplätzen (8) Zentriereinrichtungen für die Gurtspulen (1) aufweist.

## Claims

1. A system for storing electrical components accommodated in reels (1), wherein
- the reels (1) can be stored in storage compartments (13) of at least one racking unit (3),
- a height-adjustable gripper unit (4) for feeding the reels (1) into the storage compartments (13) and/or removing the reels (1) from the storage compartments (13) is associated with the racking unit,
- the reels (1) can be transported by a gripper unit (4) between a staging area (8) of the system and the storage compartments (13),
- the racking unit (3) has a cylinder-like bogie (9) which can be rotated about a vertical rotation axis (10) and on which the storage compartments (13) are tiered one above the other in multiple layers,
- the individual layers each have several of the circularly distributed storage compartments (13) in one plane,
- the gripper unit (4) is movably mounted on a stationary, vertical linear guide (14) arranged outside the bogie (9),
- each of the storage compartments (13) of the bogie (9) can be moved into a rotation position which can be adjusted to the gripper unit (4),
- the staging area (8) is arranged in the access region of the gripper unit (4),
- the system has a belt transport through which the reels (1) can be transported between a feed station (18) and/or a removal station (19) and the staging area (8),
- a plurality of the racking units (3) with a plurality of the gripper units (4) are arranged along a transport track (7) of the belt transport in a row (6) in a horizontal machine direction one behind the other, and wherein
- the staging areas (8) associated with the individual racking units (3) are formed by stop positions of the belt transports.

2. The system according to claim 1, **characterised in that**
the belt transport is divided into autonomous sub-transports (5) associated with the individual racking units (3).

3. The system according to claim 1 or 2, **characterised in that**
each of the racking units (3) forms a functional unit (2) with the associated sub-transport (5), the linear guide and the related gripper unit (4).

4. The system according to one of the preceding claims, **characterised in that**
a plurality of the rows (6) are arranged next to one another in a horizontal transverse direction perpendicular to the machine direction and are connected by a feed-across motion (16) of the belt transport.

5. The system according to claim 4, **characterised in that**
the racking units (3) are arranged distributed in a surface matrix.

6. The system according to one of the preceding claims, **characterised in that**
- the belt transport has an autonomous feed transport and an autonomous removal transport, and that
- the two transports are each arranged in planes lying one on top of the other.

7. The system according to one of the preceding claims, **characterised in that** the belt transport has centring devices for the reels (1), in particular at the staging areas (8).

## Revendications

1. Installation pour l'entreposage de composants électriques reçus dans des bobines de ceinture (1), dans laquelle
- les bobines de ceinture (1) sont entreposables dans des compartiments de stockage (13) d'au moins un équipement à rayonnage (3),
- à l'équipement à rayonnage (3) est associé un équipement de préhension (4) réglable en hauteur pour entrer les bobines de ceinture (1) dans les compartiments de stockage (13) et pour retirer les bobines de ceinture (1) des compartiments de stockage (13),
- les bobines de ceinture (1) sont transportables par un équipement de préhension (4) entre un emplacement de mise à disposition (8) de l'installation et les compartiments de stockage (13),
- l'équipement à rayonnage (3) comporte un bâti tournant cylindrique (9) rotatif autour d'un axe de rotation vertical (10) sur lequel les compartiments de stockage (13) sont formés en séries, en plusieurs couches, les uns au-dessus des autres,
- les couches individuelles comportent chacune dans un plan plusieurs compartiments de stockage (13) répartis circulairement,
- l'équipement de préhension (4) est monté à coulissement sur un guidage linéaire (14) vertical fixe disposé à l'extérieur du bâti tournant (9),
- chacun des compartiments de stockage (13) du bâti tournant (9) peut être déplacé dans une position de rotation ajustable sur l'équipement de préhension (4),
- l'emplacement de mise à disposition (8) est disposé dans la zone d'accès de l'équipement de préhension (4),
l'installation comporte un transport à bande par lequel les bobines de ceinture (1) sont transportables entre une position d'entrée (18) et/ou une station de sortie (19) et l'emplacement de mise à disposition (8),
- plusieurs des équipements à rayonnage (3) sont disposés avec plusieurs des équipements de préhension (4) le long d'un parcours de transport (7) du transport à bande en une série (6) les uns derrière les autres dans une direction longitudinale horizontale, et dans laquelle
- les emplacements de mise à disposition (8) associés aux équipements à rayonnage (3) individuels sont formés par des positions d'arrêt du transport à bande.

2. Installation selon la revendication 1, **caractérisée en ce que** le transport à bande est divisé en transporteurs partiels autonomes (5) associés aux équipements à rayonnage (3) individuels.

3. Installation selon la revendication 1 ou 2, **caractérisée en ce que** les équipements à rayonnage (3) forment chacun avec le transport partiel (5) associé, le guidage linéaire et l'équipement de préhension (4) correspondant une unité fonctionnelle (2).

4. Installation selon l'une des revendications précédentes, **caractérisée en ce que** plusieurs des séries (6) sont disposées côte à côte dans une direction transversale horizontale perpendiculaire à la direction longitudinale et sont reliées par un transport transversal (16) du transport à bande.

5. Installation selon la revendication 4, **caractérisée en ce que** les équipements à rayonnage (3) sont disposés de manière répartie en une matrice de surface.

6. Installation selon l'une des revendications précédentes, **caractérisée en ce que**
- le transport à bande comporte un transport d'entrée autonome et un transport de sortie autonome et **en ce que**
- les deux transports sont disposés respectivement dans des plans mutuellement superposés.

7. Installation selon l'une des revendications précédentes, **caractérisée en ce que** le transport à bande comporte en particulier aux emplacements de mise à disposition (8) des équipements de centrage pour les bobines de ceinture (1).
